# EUROPÄISCHE PATENTSCHRIFT

(11) **EP 3 057 190 B1**
(45) Veröffentlichungstag und Bekanntmachung des Hinweises auf die Patenterteilung: **04.04.2018**
(21) Anmeldenummer: 15154434.3
(22) Anmeldetag: 10.02.2015
(51) Int. Cl.: H02H 3/00, H02H 3/33, G01R 31/02, H02H 11/00

(54) **Fehlerstromschutzeinrichtung und Verfahren zur Kalibrierung derselben**
Fault current protection device and method for calibrating the same
Dispositif de courant différentiel et son procédé d'étalonnage

(43) Veröffentlichungstag der Anmeldung: 17.08.2016
(73) Patentinhaber: PC Electric Ges.m.b.H., 4973 St. Martin i.I. (AT)
(72) Erfinder: Irsigler, Thomas, 4780 Schärding (AT)
(74) Vertreter: KLIMENT & HENHAPEL

(56) Entgegenhaltungen:
- DE-A1-102005 028 881
- US-A1- 2005 225 909
- US-A1- 2013 128 396

## Beschreibung

### GEBIET DER ERFINDUNG

Die vorliegende Erfindung betrifft eine Fehlerstromschutzeinrichtung umfassend einen Differenzstrom-Transformator, der eine Primärwicklung beinhaltend mindestens einen Phasenleiter und einen Nullleiter aufweist sowie einen Kern, eine Sekundärwicklung und eine Prüfwicklung, mit welcher der Differenzstrom-Transformator mit einem Prüfstrom beaufschlagbar ist, um einen definierten Differenzstrom zu simulieren, die Fehlerstromschutzeinrichtung weiters umfassend eine Steuereinheit, um die Prüfwicklung zur Erzeugung des Prüfstroms anzusteuern und um eine in der Sekundärwicklung induzierte Sekundärspannung und/oder einen aus der induzierten Sekundärspannung resultierenden Sekundärstrom zu messen.

Weiters betrifft die vorliegende Erfindung ein Verfahren zur Kalibrierung einer Fehlerstromschutzeinrichtung, welche einen Differenzstrom-Transformator umfasst, der eine Primärwicklung beinhaltend mindestens einen Phasenleiter und einen Nullleiter aufweist sowie einen Kern, eine Sekundärwicklung und eine Prüfwicklung, wobei das Verfahren die folgenden Schritte umfasst:
- Beaufschlagen des Differenzstrom-Transformators (12) mit einem Prüfstrom mittels der Prüfwicklung (20), um einen definierten Differenzstrom zu simulieren;
- Messen eines Spannungswerts einer durch den Prüfstrom verursachten, in der Sekundärwicklung (19) induzierten Sekundärspannung und/oder eines Stromwerts eines aus der induzierten Sekundärspannung resultierenden Sekundärstroms;.

### STAND DER TECHNIK

Den sicheren Betrieb von elektrischen Betriebsmitteln, insbesondere von Elektrowerkzeugen bei Bau- und Montagearbeiten zu gewährleisten, ist eine Herausforderung, da insbesondere bei Baustellen fehlerhafte Elektroinstallationen nicht auszuschließen sind. Um die Sicherheit von Benutzern der elektrischen Betriebsmittel zu erhöhen, wird daher eine ortsveränderliche Fehlerstromschutzeinrichtung (manchmal auch als "portable residual current device" oder einfach als "PRCD" bezeichnet) an das über die vorhandenen Elektroinstallationen zur Verfügung gestellte Niederspannungsnetz angeschlossen. Die elektrischen Betriebsmittel, insbesondere Elektrowerkzeuge werden dann an die ortsveränderliche Fehlerstromschutzeinrichtung - und nicht direkt an das Niederspannungsnetz - angeschlossen. Grundsätzlich sind aber natürlich auch bei fertiggestellten Elektroinstallationen zur Bereitstellung eines Niederspannungsnetzes Fehlerstromschutzeinrichtungen vorzusehen. Unter Niederspannungsnetz wird dabei ein Wechselstromnetz mit einer effektiven Spannung von typischerweise 130 V bis 1000 V, insbesondere von 230 V bis 400 V verstanden.

Zur Erfassung des Fehlerstroms in Fehlerstromschutzeinrichtungen kommt üblicherweise ein Summenstromwandler bzw. Differenzstrom-Transformator zum Einsatz. Die zu überwachenden Leiter, welche aus mindestens einem Phasenleiter und einem Nullleiter bestehen, bilden eine Primärseite mit einer Primärwicklung dieses Transformators. Im Normalbetrieb hebt sich deren magnetische Wirkung auf Grund der einander entgegengesetzten Leitungsführung auf. Nur bei Vorliegen eines Fehlerstroms bzw. Differenzstroms, der auf Grund eines Fehlers vorzugsweise gegen Erde abfließt, wird eine Spannung bzw. Sekundärspannung in einer Sekundärwicklung bzw. in einer Sekundärseite des Transformators induziert. Liegen die induzierte Sekundärspannung und/oder ein damit verbundener Sekundärstrom über festgesetzten Schwellwerten, wird dies von der Fehlerstromschutzeinrichtung als Fehler erkannt. Hierauf werden die Leitungen von der Fehlerstromschutzeinrichtung, vorzugsweise mittels dafür vorgesehener Schaltkontakte und einem Schaltmittel (z.B. Relais), unterbrochen.

Der Transformator weist üblicherweise einen Kern, vorzugsweise aus Eisen oder Ferrit auf. Der magnetische Fluss, der zur Auslösung führt, ist im Vergleich zur möglichen Magnetisierung des Kerns eher gering. Das Kernmaterial besitzt je nach verwendetem Material eine mehr oder weniger stark ausgeprägte magnetische Remanenz. Eine starke Magnetisierung aufgrund eines sehr großen Differenzstroms beispielsweise durch einen Kurzschluss zwischen einem Phasenleiter und einem Schutzleiter kann den Kern in Sättigung treiben. Weiters kann eine starke Magnetisierung auch durch kurzzeitig beim Einschalten auftretende Impulsströme zwischen dem mindestens einen Phasenleiter bzw. dem Nullleiter und dem Schutzleiter hervorgerufen werden. Derartige Impulsströme werden z.B. von zur Funkentstörung eingesetzten Entstörkondensatoren der Klasse Y verursacht. Durch die starke Magnetisierung kann sich der Arbeitspunkt des Transformators entlang dessen Remanenz-Kennlinie dauerhaft verschieben. Man spricht hier auch von einer magnetischen Hysterese.

In der Praxis führt dies zu einer Änderung der Sensitivität des Transformators bzw. der Fehlerstromschutzeinrichtung, typischerweise im Bereich bis zu ±50%. Infolge dessen verschiebt sich die Auslöseschwelle, und die Fehlerstromschutzeinrichtung kann unempfindlicher, in manchen Fällen aber auch empfindlicher als gewollt reagieren. Insbesondere der erstere Fall birgt ein erhebliches Sicherheitsrisiko für Benutzer.

Aus der US 2013/128396 A1 sind eine Vorrichtung und ein Verfahren zur präzisen Messung absoluter Ströme durch den Nullleiter und den Phasenleiter bekannt, wobei eine Fehlerstromdetektion durch Rechenoperationen zur Verfügung gestellt werden kann. Um auch bei hohen Strömen eine hinreichende Genauigkeit der Messung zu ermöglichen, ist eine Kalibration der verwendeten Messvorrichtungen, die vorzugsweise als Shunts ausgeführt sind, vorgesehen, wobei diese gegeneinander mittels eines Korrekturfaktors abgeglichen werden. Darüberhinaus kann die Vorrichtung weiters eine Messvorrichtung zur direkten Messung des Differenzstroms aufweisen.

Aus der DE 102005028881 A1 ist ein Fehlerstromanalysator mit einem Summenstromwandler bekannt, dessen Ausgangssignal ausgewertet wird. Darüberhinaus sind Mittel zur Selbstkalibration vorgesehen, insbesondere ein Stromgenerator, mit dem der Summenstromwandler mit einem simulierten Fehlerstrom beaufschlagt werden kann. Wie diese Kalibrierung im Detail erfolgt, wird jedoch nicht offenbart.

Aus der US 2005/225909 A1 ist ein Schutzschalter bekannt, welcher einen Transformator aufweist. Der Transformator, durch welchen die Phasen geführt sind, umfasst eine Sekundärwindung sowie eine Tertiärwindung. In Serie mit der Tertiärwindung ist ein kalibrierter Widerstand geschaltet, was zur Erzeugung eines definierten Fehlerstroms zu Kalibrationszwecken dient. Dabei wird in der Sekundärwindung ein definierter Strom induziert, der mittels einer Überwachungsvorrichtung angezeigt werden kann. Zur Kalibration kann ein einstellbarer Widerstand der Überwachungsvorrichtung von einem Benutzer derart verändert werden, dass der angezeigte Strom mit dem vorgegebenen Strom übereinstimmt.

### AUFGABE DER ERFINDUNG

Es ist daher Aufgabe der vorliegenden Erfindung eine Fehlerstromschutzeinrichtung zur Verfügung zu stellen, die die oben geschilderten Nachteile, insbesondere eine zu geringe Empfindlichkeit auf Fehlerströme bzw. Differenzströme vermeidet.

### DARSTELLUNG DER ERFINDUNG

Erfindungsgemäß wird die oben genannte Aufgabe gelöst, indem eine sich selbst kalibrierende Fehlerstromschutzeinrichtung sowie ein Verfahren zur Kalibrierung der Fehlerstromschutzeinrichtung zur Verfügung gestellt werden. Hierzu ist es bei einer Fehlerstromschutzeinrichtung umfassend einen Differenzstrom-Transformator, der eine Primärwicklung beinhaltend mindestens einen Phasenleiter und einen Nullleiter aufweist sowie einen Kern, eine Sekundärwicklung und eine Prüfwicklung, mit welcher der Differenzstrom-Transformator mit einem Prüfstrom beaufschlagbar ist, um einen definierten Differenzstrom zu simulieren, die Fehlerstromschutzeinrichtung weiters umfassend eine Steuereinheit, um die Prüfwicklung zur Erzeugung des Prüfstroms anzusteuern und um eine in der Sekundärwicklung induzierte Sekundärspannung und/oder einen aus der induzierten Sekundärspannung resultierenden Sekundärstrom zu messen, erfindungsgemäß vorgesehen, dass die Steuereinheit zur Kalibrierung der Fehlerstromschutzeinrichtung so ausgelegt ist, dass bei einer Abweichung des gemessenen Spannungswerts der durch den Prüfstrom verursachten Sekundärspannung von einem Spannungssollwert und/oder bei einer Abweichung des gemessenen Stromwerts des durch den Prüfstrom verursachten Sekundärstroms von einem Stromsollwert ein Korrekturfaktor berechnet wird, mit dem gemessene Spannungswerte der durch Differenzströme verursachten Sekundärspannung und/oder gemessene Stromwerte des durch Differenzströme verursachten Sekundärstroms multipliziert werden.

Analog ist es bei einem Verfahren zur Kalibrierung einer Fehlerstromschutzeinrichtung, welche einen Differenzstrom-Transformator umfasst, der eine Primärwicklung beinhaltend mindestens einen Phasenleiter und einen Nullleiter aufweist sowie einen Kern, eine Sekundärwicklung und eine Prüfwicklung, erfindungsgemäß vorgesehen, dass das Verfahren die folgenden Schritte umfasst:
- Beaufschlagen des Differenzstrom-Transformators mit einem Prüfstrom mittels der Prüfwicklung, um einen definierten Differenzstrom zu simulieren;
- Messen eines Spannungswerts einer durch den Prüfstrom verursachten, in der Sekundärwicklung induzierten Sekundärspannung und/oder eines Stromwerts eines aus der induzierten Sekundärspannung resultierenden Sekundärstroms;
- Berechnen eines Korrekturfaktors, wenn der gemessene Spannungswert von einem Spannungssollwert und/oder der gemessene Stromwert von einem Stromsollwert abweicht;
- Multiplizieren von gemessenen Spannungswerten der durch Differenzströme verursachten Sekundärspannung und/oder von gemessenen Stromwerten des durch Differenzströme verursachten Sekundärstroms mit dem Korrekturfaktor.

Neben dem mindestens einen Phasenleiter und dem Nullleiter kann auch ein Schutzleiter einen Teil der Primärwicklung bilden. In diesem Fall wird der Schutzleiter in an sich bekannter Weise "verkehrt" geführt, sodass sich ein durch ihn über den mindestens einen Phasenleiter und einen Verbraucher fließender Fehlerstrom in der Wirkung nicht aufhebt, sondern verstärkt.

Die in der Sekundärwicklung induzierte Spannung wird durch einen Differenzstrom zwischen dem mindestens einen Phasenleiter und dem Nullleiter oder durch den Prüfstrom, der einen definierten Differenzstrom simuliert, verursacht. Dabei induziert der mit dem jeweiligen Strom einhergehende magnetische Fluss die Sekundärspannung. Bei dem Prüfstrom handelt es sich vorzugsweise um einen sehr genau definierten, sinusförmigen Wechselstrom, um einen definierten Differenzstrom zwischen dem mindestens einen Phasenleiter und dem Nullleiter zu simulieren. Der Prüfstrom wird von der Steuereinheit erzeugt, die hierfür entsprechende, von mindestens einem Mikroprozessor kontrollierte Elektronik aufweist.

Bei der Messung der Sekundärspannung bzw. des Sekundärstroms, der aufgrund der induzierten Sekundärspannung durch die Sekundärwicklung fließt, ist es vorzugsweise vorgesehen, dass die Steuereinheit die Sekundärspannung / den Sekundärstrom verstärkt und mittels eines Analog-Digital-Umsetzers ein digitales Signal generiert, welches mittels des mindestens einen Mikroprozessors verarbeitet und ausgewertet wird.

Der Korrekturfaktor ergibt sich grundsätzlich aus dem Quotienten aus Sollwert (Dividend) und Messwert (Divisor). Auf diese Weise kann diversen Einflussgrößen, wie z.B. der Alterung bzw. dem aktuellen Alter der Fehlerstromschutzeinrichtung, einem bekannten Hystereseverhalten des Kerns bzw. des Kernmaterials oder Bauteiltoleranzen, Rechnung getragen werden. Einzig Fehler, die sich aus einer mangelnden Genauigkeit des Prüfstroms, insbesondere seiner Amplitude, ergeben, sind hierbei nicht berücksichtigt. Vorzugsweise wird die Genauigkeit des Prüfstroms bei der Produktion der Fehlerstromschutzeinrichtung eingestellt bzw. gemessen und als Wert abgespeichert, sodass die Genauigkeit ggf. im Korrekturfaktor berücksichtigt werden kann. Dabei ist über die Spezifikation der Bauteile die Langzeitstabilität der Genauigkeit des Prüfstroms gegeben. Typischerweise ergibt sich ein zulässiger Bereich für den Korrekturfaktor von inklusive 0,8 bis inklusive 1,25.

Ist die festgestellte Abweichung des Messwerts vom Sollwert jedoch größer als sie unter Berücksichtigung der bekannten Einflussgrößen - insbesondere unter Berücksichtigung der magnetischen Hysterese des Kerns, der Bauteiltoleranzen und der Alterung der Fehlerstromschutzeinrichtung - sein darf, so ergibt sich ein zu großer oder zu kleiner Korrekturfaktor. Es erfolgt keine Korrektur bzw. Kalibrierung, sondern es wird ein Kalibrierungs-Fehlerzustand festgestellt. Dieser wird vorzugsweise signalisiert, beispielsweise mittels einer Leuchtdiode. Daher ist es erfindungsgemäß weiters vorgesehen, dass die Steuereinheit so ausgelegt ist, dass ein Kalibrierungs-Fehlerzustand erkannt wird, wenn der Korrekturfaktor größer als ein vorgegebener maximal zulässiger Korrekturfaktor, bevorzugt größer als 1,55, besonders bevorzugt größer als 2 ist. Bzw. ist es erfindungsgemäß weiters vorgesehen, dass die Steuereinheit so ausgelegt ist, dass ein Kalibrierungs-Fehlerzustand erkannt wird, wenn der Korrekturfaktor kleiner als ein vorgegebener minimal zulässiger Korrekturfaktor, bevorzugt kleiner als 0,65, besonders bevorzugt kleiner als 0,5 ist.

Analog ist es beim erfindungsgemäßen Verfahren weiters vorgesehen, dass ein Kalibrierungs-Fehlerzustand erkannt wird, wenn der Korrekturfaktor größer als ein vorgegebener maximal zulässiger Korrekturfaktor, bevorzugt größer als 1,55, besonders bevorzugt größer als 2 ist. Bzw. ist es beim erfindungsgemäßen Verfahren weiters vorgesehen, dass ein Kalibrierungs-Fehlerzustand erkannt wird, wenn der Korrekturfaktor kleiner als ein vorgegebener minimal zulässiger Korrekturfaktor, bevorzugt kleiner als 0,65, besonders bevorzugt kleiner als 0,5 ist.

Wird kein Kalibrierungs-Fehlerzustand erkannt, so wird der von der Steuereinheit berechnete Korrekturfaktor abgespeichert und beim nächsten aufgrund eines Fehlerfalls auftretenden Differenzstrom mit dem dann gemessenen Spannungswert bzw. Stromwert multipliziert. Der so erhaltene korrigierte Spannungswert bzw. Stromwert wird in der Folge von der Steuereinheit zur Entscheidung herangezogen, ob der Differenzstrom größer als der zulässige Grenzwert ist. Falls letzteres der Fall ist, werden mittels der Steuereinheit der mindestens eine Phasenleiter und der Nullleiter ausgeschaltet. Der Schutzleiter kann je nach Ausführungsform der Fehlerstromschutzeinrichtung und Anwendungsfall z.B. ebenfalls ausgeschaltet werden oder eingeschaltet bleiben oder gegenüber dem mindestens einen Phasenleiter und dem Nullleiter zeitlich verzögert ausgeschaltet werden. Zur Gefahrenvermeidung erfolgt ein Ausschalten des mindestens einen Phasenleiters und des Nullleiters und ggf. des Schutzleiters analog auch bei Erkennung des Kalibrierungs-Fehlerzustands. Daher ist es bei einer bevorzugten Ausführungsform der erfindungsgemäßen Fehlerstromschutzeinrichtung vorgesehen, dass die Fehlerstromschutzeinrichtung mindestens einen Phasenleiter-Schaltkontakt zur ein- und ausschaltbaren Unterbrechung des mindestens einen Phasenleiters und einen Nullleiter-Schaltkontakt zur ein- und ausschaltbaren Unterbrechung des Nullleiters umfasst, wobei mindestens ein mittels der Steuereinheit ansteuerbares Schaltmittel vorgesehen ist, um die Schaltkontakte zu schalten, und wobei die Steuereinheit so ausgelegt ist, dass bei Erkennung des Kalibrierungs-Fehlerzustands die Schaltkontakte ausgeschaltet werden und/oder ein Einschalten der Schaltkontakte unterbunden wird.

Analog ist es bei einer bevorzugten Ausführungsform des erfindungsgemäßen Verfahrens vorgesehen, dass bei Erkennung des Kalibrierungs-Fehlerzustands der mindestens eine Phasenleiter und der Nullleiter unterbrochen werden und/oder bleiben.

Das Ein-Ausschalten bzw. die Unterbrechung des mindestens einen Phasenleiters und des Nullleiters sowie ggf. des Schutzleiters erfolgt vorzugsweise ausgangsseitig. Dies stellt sicher, dass die Steuereinheit stets mit Spannung versorgt bleibt und arbeiten, insbesondere die Schaltmittel für Schaltkontakte ansteuern kann. D.h. die Kalibrierung kann unbeeinflusst von einem möglichen Fehlerstrom durch einen Verbraucher erfolgen, indem der Verbraucher aufgrund der ausgangsseitigen Unterbrechung des mindestens einen Phasenleiters und des Nullleiters nicht mit Spannung versorgt ist. Bei den Schaltmitteln kann es sich beispielsweise um Relais, d.h. um elektromechanische Schaltmittel, oder um Schütze oder um steuerbare Leistungsschalter mit mechanischen und/oder elektronischen Schaltelementen, insbesondere Halbleiter-Schaltelementen handeln.

Um eine Gefährdung für den Benutzer durch eine Fehlerstromeinrichtung, deren Empfindlichkeit gegenüber dem Normalzustand herabgesetzt ist, möglichst auszuschließen, ist es erfindungsgemäß vorgesehen, dass eine Kalibrierung bei jedem Einschaltvorgang der Fehlerstromschutzeinrichtung durchgeführt wird. Der Einschaltvorgang wird üblicherweise durch Betätigen einer Einschalttaste durch den Benutzer eingeleitet. Vorzugsweise werden der mindestens eine Phasenleiter und der Nullleiter nicht unmittelbar nach Betätigen der Einschalttaste freigeschaltet und damit möglicherweise ein Verbraucher mit Spannung versorgt, sondern erst nach der erfolgten Kalibrierung und nur dann, wenn kein Kalibrierungs-Fehlerzustand festgestellt worden ist.

Daher ist es bei einer bevorzugten Ausführungsform der erfindungsgemäßen Fehlerstromschutzeinrichtung vorgesehen, dass die Steuereinheit so ausgelegt ist, dass die Kalibrierung der Fehlerstromschutzeinrichtung zu Beginn jedes Einschaltens der Fehlerstromschutzeinrichtung, vorzugsweise jeweils unmittelbar nachdem eine Einschalttaste der Fehlerstromschutzeinrichtung durch einen Benutzer betätigt worden ist, durchgeführt wird.

Analog ist es bei einer bevorzugten Ausführungsform des erfindungsgemäßen Verfahrens vorgesehen, dass das erfindungsgemäße Verfahren zu Beginn jedes Einschaltens der Fehlerstromschutzeinrichtung, vorzugsweise jeweils unmittelbar nachdem eine Einschalttaste der Fehlerstromschutzeinrichtung durch einen Benutzer betätigt worden ist, durchgeführt wird.

Typischerweise verzögert sich dadurch der Einschaltvorgang um maximal 200 ms, vorzugsweise maximal 100 ms. D.h. diese Zeitspanne kann zwischen dem Betätigen der Einschalttaste durch den Benutzer und der Freischaltung der Spannungsversorgung an weiterführenden Anschlüssen der Fehlerstromschutzeinrichtung, mit welchen weiterführenden Anschlüssen Verbraucher elektrisch verbunden werden können, verstreichen. Eine solche Zeitspanne wird vom Benutzer kaum wahrgenommen und üblicherweise nicht als störend empfunden. Dies insbesondere auch deshalb, da sich für die Entprellung der Einschalttaste ohnehin Zeiten ergeben, die im Bereich der oben angeführten Verzögerungszeiten liegen.

Um die Sicherheit weiter zu erhöhen, ist es bei einer bevorzugten Ausführungsform der erfindungsgemäßen Fehlerstromschutzeinrichtung vorgesehen, dass die Steuereinheit so ausgelegt ist, dass die Kalibrierung der Fehlerstromschutzeinrichtung bei eingeschalteter Fehlerstromschutzeinrichtung erfolgt, vorzugsweise regelmäßig und/oder in vorgebbaren Zeitintervallen und/oder zu vorgebbaren Zeitpunkten. Dies stellt gleichzeitig eine Funktionsüberprüfung bzw. Funktionsüberwachung dar.

Analog ist es bei einer bevorzugten Ausführungsform des erfindungsgemäßen Verfahrens vorgesehen, dass das erfindungsgemäße Verfahren bei eingeschalteter Fehlerstromschutzeinrichtung durchgeführt wird, vorzugsweise regelmäßig und/oder in vorgebbaren Zeitintervallen und/oder zu vorgebbaren Zeitpunkten. Sinnvolle Zeitintervalle wären z.B. einmal pro Stunde oder einmal pro Woche.

Um während der im Betrieb stattfindenden Kalibrierung die korrekte Messung eines extern verursachten Fehlerstroms nicht zu behindern, wird vorzugsweise ein in der Amplitude reduzierter Prüfstrom verwendet. D.h. auch der jeweilige Wert der durch den reduzierten Prüfstrom verursachten Sekundärspannung bzw. des durch den reduzierten Prüfstrom verursachten Sekundärstroms ist reduziert und wird daher mit einem jeweils reduzierten Sollwert verglichen. Dabei sind die reduzierten Sollwerte für die Sekundärspannung bzw. den Sekundärstrom in der Steuereinheit hinterlegt.

Somit kann während der Kalibrierung bzw. Funktionsüberprüfung in einem ersten Schritt eine möglichst korrekte Ermittlung des extern verursachten Fehlerstroms erfolgen, weil das System nicht übersteuert wird. Hierzu wird der reduzierte Sollwert vom aktuellen Messwert abgezogen und die sich ergebende Differenz mit dem aktuellen Korrekturfaktor multipliziert. Liegt das Ergebnis über dem maximal zulässigen Fehlerstrom bzw. Auslösewert, löst die Fehlerstromschutzeinrichtung aus. Andernfalls wird im nächsten Schritt überprüft, ob der aktuelle Korrekturfaktor noch gültig ist, und der Korrekturfaktor ggf. aktualisiert.

Weil diese Messung im laufenden Betrieb erfolgt, kann das Ergebnis durch vom Verbraucher verursachte schwankende Fehlerströme gestört werden. Dementsprechend können mehrere Messungen und eine entsprechende Filterung bzw. Mittelwertbildung vorgesehen sein. D.h. die Aktualisierung des Korrekturfaktors erfolgt dann nicht nach einer einzelnen Messung, sondern nach mehreren Messungen anhand des gefilterten bzw. gemittelten Werts für den Korrekturfaktor.

Hierdurch kann insbesondere einer altersbedingt auftretenden Änderung der Sensitivität der Fehlerstromschutzeinrichtung Rechnung getragen werden. D.h. die Empfindlichkeit der Fehlerstromeinrichtung kann sich typischerweise über längere Zeiträume ändern, auch wenn in diesen Zeiträumen keine hohen Differenzströme - und damit einhergehend hohe magnetische Flüsse - auftreten. Beispielsweise kann ein starkes äußeres Magnetfeld am Ort der Fehlerstromschutzeinrichtung zu einer Änderung der magnetischen Flussdichte des Kerns führen. Weiters kann die Temperatur einen merklichen Einfluss auf den Kern des Differenzstrom-Transformators haben, aber auch auf den elektrischen Widerstand der Wicklungen, insbesondere der Sekundärwicklung.

Um auch dann eine sichere Stromversorgung von elektrischen Betriebsmitteln zur Verfügung stellen zu können, wenn diese an unterschiedlichsten Orten, insbesondere auf Baustellen benutzt werden, ist es bei einer bevorzugten Ausführungsform der erfindungsgemäßen Fehlerstromschutzeinrichtung vorgesehen, dass es sich um eine ortsveränderliche Fehlerstromschutzeinrichtung handelt. Eine solche ortsveränderliche Fehlerstromschutzeinrichtung, die oft auch als PRCD bezeichnet wird, wird an der jeweiligen Baustelle mit dem dort vorhandenen Niederspannungsnetz verbunden. Indem die elektrischen Betriebsmittel, insbesondere Elektrowerkzeug wie Bohrmaschinen, Winkelschleifer etc. dann nur noch an das PRCD angeschlossen werden, ist eine maximale Sicherheit gewahrt.

Entsprechend ist für die sichere Stromversorgung von elektrischen Betriebsmitteln, insbesondere auf Baustellen, erfindungsgemäß ein System zur lokalen Bereitstellung von Wechselstrom vorgesehen, umfassend eine erfindungsgemäße Fehlerstromschutzeinrichtung, wobei der Schutzleiter der Fehlerstromschutzeinrichtung mit dem Schutzleiter des Niederspannungsnetzes elektrisch verbunden ist, wobei der Nullleiter der Fehlerstromschutzeinrichtung mit dem Nullleiter des Niederspannungsnetzes elektrisch verbunden ist und wobei der mindestens eine Phasenleiter der Fehlerstromschutzeinrichtung mit dem mindestens einen Phasenleiter des Niederspannungsnetzes elektrisch verbunden ist.

### KURZE BESCHREIBUNG DER FIGUREN

Die Erfindung wird nun anhand eines(von) Ausführungsbeispiels(en) näher erläutert. Die Zeichnungen sind beispielhaft und sollen den Erfindungsgedanken zwar darlegen, ihn aber keinesfalls einengen oder gar abschließend wiedergeben.

Dabei zeigt:
- Fig. 1: eine schematische Darstellung einer erfindungsgemäßen Fehlerstromschutzeinrichtung
- Fig. 2: eine schematische Darstellung einer weiteren Ausführungsform der erfindungsgemäßen Fehlerstromschutzeinrichtung mit drei Phasenleitern

### WEGE ZUR AUSFÜHRUNG DER ERFINDUNG

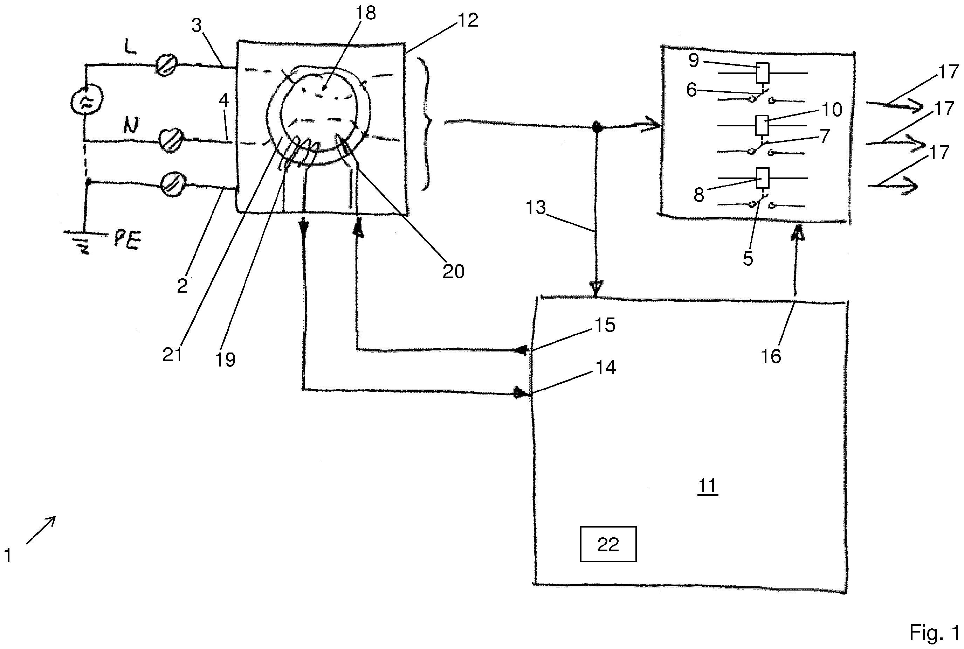

In der schematischen Darstellung der Fig. 1 ist eine erfindungsgemäße Fehlerstromschutzeinrichtung 1 für ein Niederspannungsnetz gezeigt, die an ein einphasiges Niederspannungsnetz angeschlossen ist. Dabei ist ein Schutzleiter 2 der Fehlerstromschutzeinrichtung 1 mit einem Schutzleiter PE des Niederspannungsnetzes verbunden, ein Nullleiter 4 der Fehlerstromschutzeinrichtung 1 mit einem Nullleiter N des Niederspannungsnetzes und ein Phasenleiter 3 der Fehlerstromschutzeinrichtung 1 mit einem Phasenleiter L des Niederspannungsnetzes.

In den Schutzleiter 2 ist ein Schutzleiter-Schaltkontakt 5 geschaltet, um den Schutzleiter 2 ausgangsseitig ein- und ausschaltbar unterbrechen zu können. Analog ist in den Phasenleiter 3 ein Phasenleiter-Schaltkontakt 6 geschaltet, um den Phasenleiter 3 ausgangsseitig ein- und ausschaltbar unterbrechen zu können. Ebenso ist in den Nullleiter 4 ein Nullleiter-Schaltkontakt 7 geschaltet, um den Nullleiter 4 ausgangsseitig ein- und ausschaltbar unterbrechen zu können. Die Schaltkontakte 5, 6, 7 sind mit weiterführenden Anschlüssen 17 elektrisch verbunden, über welche elektrische Betriebsmittel bzw. Verbraucher mit Spannung versorgt bzw. mit dem Schutzleiter 2, dem Phasenleiter 3 und dem Nullleiter 4 elektrisch verbunden werden können.

Zum Schalten des Schutzleiter-Schaltkontakts 5 ist ein Relais 8 vorgesehen, zum Schalten des Phasenleiter-Schaltkontakts 6 ein Relais 9 und zum Schalten des Nullleiter-Schaltkontakts 7 ein Relais 10. Die Relais 8, 9, 10 werden über eine Steuereinheit 11 angesteuert, die über Leitungen 13 mit Strom versorgt wird (in Fig. 1 ist aus Übersichtlichkeitsgründen nur eine Leitung eingezeichnet). In Fig. 1 sind die Leitungen 13 nach dem Differenzstrom-Transformator 12 angeordnet. Es sei jedoch bemerkt, dass selbstverständlich auch eine Anordnung vor dem Differenzstrom-Transformator 12 möglich ist, dass also die Stromversorgung der Steuereinheit 11 auch vor dem Differenzstrom-Transformator 12 abgegriffen werden kann. Die Stromversorgung der Steuereinheit 11 über die Leitungen 13 ist aber jedenfalls unabhängig von der Stellung der Schalter 5, 6, 7 .

Die Steuereinheit 11 weist mindestens einen Ausgang 16 zur Ansteuerung der Relais 8, 9, 10 auf (in Fig. 1 ist aus Übersichtlichkeitsgründen nur ein solcher Ausgang eingezeichnet). Dabei ist die Fehlerstromschutzeinrichtung 1 bzw. die Steuereinheit 11 vorzugsweise so ausgelegt, dass der Schutzleiter-Schaltkontakt 5 unabhängig vom Phasenleiter-Schaltkontakt 6 und vom Nullleiter-Schaltkontakt 7 geschaltet werden kann. Besonders bevorzugt können auch die Schaltkontakte 6, 7 unabhängig voneinander geschaltet werden. Grundsätzlich sind aber auch Ausführungsvarianten denkbar, bei denen die Schaltkontakte 5, 6, 7 nicht unabhängig voneinander, sondern stets gleich geschaltet werden, beispielsweise über eine gemeinsame Schaltbrücke, für die dann nur ein Relais notwendig wäre.

Zur Detektion eines Fehlerstroms weist die Fehlerstromschutzeinrichtung 1 einen Summenstromwandler bzw. Differenzstrom-Transformator 12 auf. Der Differenzstrom-Transformator weist eine Primärseite mit einer Primärwicklung 18 und eine Sekundärseite mit einer Sekundärwicklung 19 auf.

Die Primärwicklung 18 wird dabei im gezeigten Ausführungsbeispiel durch jeweils einen Abschnitt des Phasenleiters 3 und des Nullleiters 4 gebildet. Weiters umfasst der Differenzstrom-Transformator 12 einen Kern 21, der aus einem ferromagnetischen, insbesondere weichmagnetischen Werkstoff, typischerweise aus Eisen oder Ferrit besteht. Im gezeigten Ausführungsbeispiel ist der Kern 21 ringförmig, wobei die Primärwicklung 18 bzw. die entsprechenden Abschnitte des Phasenleiters 3 und des Nullleiters 4 durch den Kern 21 hindurch verlaufend angeordnet sind. Die Sekundärwicklung 21 umfasst einen Leiter, der mit mehreren Windungen um einen Abschnitt des Kerns 21 herum angeordnet ist.

Im Normalbetrieb, ohne Vorliegen eines Differenzstromes, ist die vorzeichenbehaftete Summe aller Ströme auf der Primärseite bzw. in der Primärwicklung 18 null. Entsprechend heben sich auch die magnetischen Flüsse, die mit den Strömen im Phasenleiter 3 und im Nullleiter 4 verbunden sind, in der Primärwicklung 18 auf, sodass keine Spannung in der Sekundärwicklung 19 induziert wird.

Kommt es hingegen dazu, dass ein Strom - möglicherweise sogar über einen Benutzer! - gegen Erde abfließt, so ist die vorzeichenbehaftete Summe aller Ströme in der Primärwicklung 18 ungleich null. D.h. ein Differenzstrom zwischen dem Phasenleiter 3 und dem Nullleiter 4 bzw. zwischen dem Phasenleiter L und dem Nullleiter N liegt vor, der wiederum mit einem von der Primärwicklung 18 erzeugten magnetischen Fluss ungleich null einhergeht. Da es sich bei den betrachteten Strömen, also auch beim Differenzstrom, um Wechselströme handelt, ist auch der durch den Differenzstrom verursachte magnetische Fluss zeitlich veränderlich. Es kommt daher zu einer Induktion einer Sekundärspannung in der Sekundärwicklung 19 und ggf. zu einem aus der Sekundärspannung resultierenden Sekundärstrom durch die Sekundärwicklung 19 auf der Sekundärseite. Die Sekundärspannung bzw. der Sekundärstrom sind dabei proportional zum Differenzstrom.

Die Steuereinheit 11 weist einen Eingang 14 zur Messung für die in der Sekundärwicklung 19 induzierte Sekundärspannung bzw. für den aus der Sekundärspannung resultierenden Sekundärstrom auf. Bei der Messung der Sekundärspannung bzw. des Sekundärstroms, der aufgrund der induzierten Sekundärspannung durch die Sekundärwicklung 19 fließt, ist es vorzugsweise vorgesehen, dass die Steuereinheit 11 die Sekundärspannung / den Sekundärstrom verstärkt und mittels eines Analog-Digital-Umsetzers ein digitales Signal generiert, welches mittels zumindest eines Mikroprozessors verarbeitet und ausgewertet wird.

Grundsätzlich kann ein Fehlerfall erkannt werden, wenn die gemessene Sekundärspannung bzw. der gemessene Sekundärstrom über einem festgelegten, vorzugsweise in der Steuereinheit 11 einstellbaren Grenzwert liegt. Wird ein solcher Fehlerfall erkannt, erfolgt üblicherweise ein Ausschalten der Schaltkontakte 6, 7 bzw. bleiben die Schaltkontakte 6, 7 ausgeschaltet. An den weiterführenden Anschlüssen 17 steht dann keine Spannung zur Verfügung. Vorzugsweise kann der Schutzleiter-Schaltkontakt 5 eingeschaltet bleiben bzw. trotz Vorliegen des Fehlerfalls eingeschaltet werden. Es ist aber natürlich auch denkbar, auch den Schutzleiter-Schaltkontakt 5 auszuschalten.

Der Vergleich der genannten Messwerte mit einem Grenzwert setzt voraus, dass ein gewisser Differenzstrom tatsächlich eine gewisse Sekundärspannung bzw. einen gewissen Sekundärstrom zur Folge hat, d.h. dass ein gewisses Übertragungsmaß gegeben ist. Das Übertragungsmaß kann jedoch in der Praxis durch unterschiedliche Einflussgrößen verändert werden. Insbesondere kann sich aufgrund einer Remanenz des Kerns 21 der Arbeitspunkt des Differenzstrom-Transformators 12 ändern, wenn der Kern 21 großen magnetischen Flüssen ausgesetzt wird, da der Kern 21 eine magnetische Hysterese durchläuft. Weiters spielen z.B. Bauteiltoleranzen sowie die Alterung der Fehlerstromschutzeinrichtung 1 eine Rolle. All diese Einflussgrößen können also dazu führen, dass sich die Empfindlichkeit der Fehlerstromschutzeinrichtung 1 ändert. Insbesondere wenn sich die Empfindlichkeit dahingehend ändert, dass ein Differenzstrom, der eigentlich eine Sekundärspannung bzw. einen Sekundärstrom nach sich ziehen sollte, die über den einen Fehlerfall definierenden Grenzwerten liegen, eine Sekundärspannung bzw. einen Sekundärstrom verursacht, die unter diesen Grenzwerten liegen, stellt dies eine große Gefahr für den Benutzer dar. Erfindungsgemäß wird dieser Gefahr bzw. einer sich ändernden Empfindlichkeit der Fehlerstromeinrichtung 1 begegnet, indem die Fehlerstromeinrichtung 1 kalibriert wird.

Hierzu wird der Differenzstrom-Transformator 12 mit einem wohldefinierten Prüfstrom, vorzugsweise mit einem sinusförmigen Prüfstrom mit genau festgelegter Amplitude, die typischerweise einem Auslösewert der Fehlerstromschutzeinrichtung 1 entspricht oder in einem Bereich von ±10% rund um den Auslösewert liegt, beaufschlagt, um einen definierten Differenzstrom zu simulieren. Typische Auslösewerte sind 10 mA, 30 mA oder 100 mA. Die Sekundärwicklung 19 ist entsprechend angepasst.

Die Beaufschlagung mit dem Prüfstrom geschieht mittels einer Prüfwicklung 20, die im gezeigten Ausführungsbeispiel mit mindestens einer Windung um einen Abschnitt des Kerns 21 angeordnet ist. Der Prüfstrom wird von der Steuereinheit 11 erzeugt, die hierfür entsprechende, vorzugsweise vom mindestens einen Mikroprozessor kontrollierte Elektronik aufweist. Dabei steuert die Steuereinheit 11 die Prüfwicklung 20 über einen Ausgang 15 an.

Hierauf werden die induzierte Sekundärspannung bzw. der resultierende Sekundärstrom mittels der Steuereinheit 11 gemessen und mit einem Spannungssollwert bzw. einem Stromsollwert verglichen. Bei einem Auslösewert von primärseitig 30 mA Fehlerstrom liegt die durch einen Fehler- bzw. Differenzstrom von 30 mA induzierte Sekundärspannung typischerweise im Bereich von 1 mV bis 5 mV. Entsprechend liegt der Sollwert für die durch einen Prüfstrom von 30 mA verursachte Sekundärspannung in diesem Bereich.

Weichen die Messwerte von den Sollwerten ab, so wird von der Steuereinheit 11 ein Korrekturfaktor berechnet, der sich grundsätzlich aus dem Quotienten aus Sollwert (Dividend) und Messwert (Divisor) ergibt. Auf diese Weise kann diversen bekannten Einflussgrößen, wie z.B. der Alterung bzw. dem aktuellen Alter der Fehlerstromschutzeinrichtung 1, einem bekannten Hystereseverhalten des Kerns 21 bzw. des Kernmaterials oder Bauteiltoleranzen, Rechnung getragen werden. Typischerweise liegt der Korrekturfaktor im Bereich von inklusive 0,8 bis inklusive 1,25.

Der berechnete Korrekturfaktor wird von der Steuereinheit 11 gespeichert und in weiterer Folge mit den Sekundärspannungswerten bzw. Sekundärstromwerten, die als Folge von auftretenden Differenzströmen gemessen werden, multipliziert. Die so korrigierten Messwerte werden nun mit den Grenzwerten verglichen um zu entscheiden, ob ein Fehlerfall vorliegt oder nicht. Im Fehlerfall erfolgt das oben bereits beschriebene Abschalten der Schaltkontakte 6, 7 und ggf. des Schutzleiter-Schaltkontakts 5 bzw. bleiben die Schaltkontakte 6, 7 und ggf. der Schutzleiter-Schaltkontakt 5 abgeschaltet.

Es kann jedoch auch der Fall eintreten, dass bei der Durchführung der Kalibrierung die festgestellte Abweichung des jeweiligen Messwerts vom Sollwert größer ist, als sie unter Berücksichtigung der bekannten Einflussgrößen - insbesondere unter Berücksichtigung der magnetischen Hysterese des Kerns 21, der Bauteiltoleranzen und der Alterung der Fehlerstromschutzeinrichtung 1 - sein darf, sodass sich ein zu großer oder zu kleiner Korrekturfaktor ergibt. Dies ist vorzugsweise dann der Fall, wenn der Korrekturfaktor größer als 1,65, insbesondere größer als 2 bzw. kleiner als 0,65, insbesondere kleiner als 0,5 ist. Es erfolgt dann keine Korrektur bzw. Kalibrierung, sondern es wird von der Steuereinheit 11 ein Kalibrierungs-Fehlerzustand festgestellt. Dieser wird vorzugsweise signalisiert, beispielsweise mittels einer Leuchtdiode (nicht dargestellt). Wie bei einem Fehlerfall aufgrund eines zu großen Differenzstroms erfolgt dann das oben bereits beschriebene Abschalten der Schaltkontakte 6, 7 und ggf. des Schutzleiter-Schaltkontakts 5 bzw. bleiben die Schaltkontakte 6, 7 und ggf. der Schutzleiter-Schaltkontakt 5 abgeschaltet.

Um eine Gefährdung für den Benutzer durch eine gegenüber dem Normalzustand gestörte Empfindlichkeit der Fehlerstromeinrichtung 1 möglichst auszuschließen, ist es erfindungsgemäß vorgesehen, dass die Kalibrierung der Fehlerstromschutzeinrichtung 1 zu Beginn jedes Einschaltens der Fehlerstromschutzeinrichtung 1 erfolgt. Dabei erfolgt das Einschalten, indem der Benutzer eine Einschalttaste 22 betätigt. Der Phasenleiter 3 und der Nullleiter 4 werden also nicht unmittelbar nach Betätigen der Einschalttaste 22 freigeschaltet und damit möglicherweise ein Verbraucher, der mit den weiterführenden Anschlüssen 17 elektrisch verbunden ist, mit Spannung versorgt, sondern erst nach der erfolgten Kalibrierung und nur dann, wenn kein Kalibrierungs-Fehlerzustand festgestellt worden ist. Typischerweise verzögert sich dadurch der Einschaltvorgang um maximal 200 ms, vorzugsweise maximal 100 ms, was im Bereich jener Zeit liegt, die für eine Entprellung der Einschalttaste 22 benötigt wird.

Weiters kann die Kalibrierung auch während des Betriebs, also bei eingeschalteter Fehlerstromschutzeinrichtung 1 durchgeführt werden, insbesondere regelmäßig und/oder in vorgebbaren Zeitintervallen und/oder zu vorgebbaren Zeitpunkten. Dies stellt gleichzeitig eine Funktionsüberprüfung bzw. Funktionsüberwachung dar. Die Steuereinheit 11 kann entsprechend programmiert werden, um die Zeitpunkte zur Durchführung der Kalibrierung festzulegen. Typische Zeitintervalle wären einmal pro Stunde oder einmal pro Woche.

Um während der im Betrieb stattfindenden Kalibrierung die korrekte Messung eines extern verursachten Fehlerstroms nicht zu behindern, wird vorzugsweise ein in der Amplitude reduzierter Prüfstrom verwendet. D.h. auch der jeweilige Wert der durch den reduzierten Prüfstrom verursachten Sekundärspannung bzw. des durch den reduzierten Prüfstrom verursachten Sekundärstroms ist reduziert und wird daher mit einem jeweils reduzierten Sollwert verglichen. Dabei sind die reduzierten Sollwerte für die Sekundärspannung bzw. den Sekundärstrom in der Steuereinheit 11 hinterlegt. Somit kann während der Kalibrierung bzw. Funktionsüberwachung in einem ersten Schritt eine möglichst korrekte Ermittlung des extern verursachten Fehlerstroms erfolgen, weil das System nicht übersteuert wird. Hierzu wird der reduzierte Sollwert vom aktuellen Messwert abgezogen und die sich ergebende Differenz mit dem aktuellen Korrekturfaktor multipliziert. Liegt das Ergebnis über dem maximal zulässigen Fehlerstrom bzw. über dem Auslösewert, löst die Fehlerstromschutzeinrichtung 1 aus. Andernfalls wird im nächsten Schritt überprüft, ob der aktuelle Korrekturfaktor noch gültig ist, und der Korrekturfaktor ggf. aktualisiert.

Weil diese Messung im laufenden Betrieb erfolgt, kann das Ergebnis durch vom Verbraucher verursachte schwankende Fehlerströme gestört werden. Dementsprechend können mehrere Messungen und eine entsprechende Filterung bzw. Mittelwertbildung vorgesehen sein. D.h. die Aktualisierung des Korrekturfaktors erfolgt dann nicht nach einer einzelnen Messung, sondern nach mehreren Messungen anhand des gefilterten bzw. gemittelten Werts für den Korrekturfaktor.

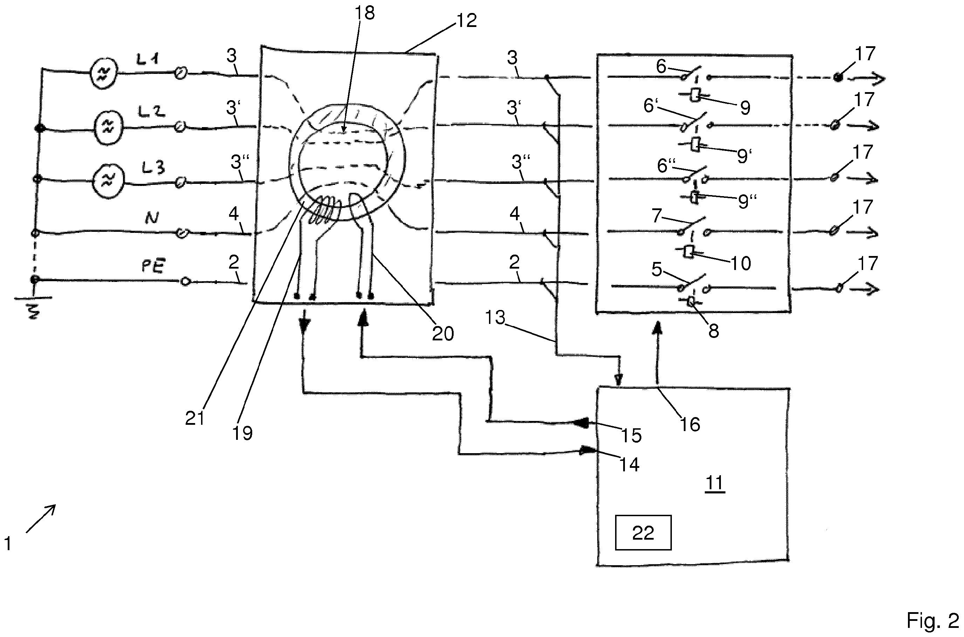

Fig. 2 zeigt eine weitere Ausführungsform der erfindungsgemäßen Fehlerstromschutzeinrichtung 1 für ein Niederspannungsnetz, die völlig analog zur in Fig. 1 gezeigten Ausführungsform aufgebaut ist, wobei das Niederspannungsnetz, mit dem die Fehlerstromschutzeinrichtung 1 verbunden ist, jedoch drei Phasenleiter L1, L2, L3 aufweist. Grundsätzlich funktioniert die in Fig. 2 gezeigte Ausführungsform der erfindungsgemäßen Fehlerstromschutzeinrichtung 1 völlig analog zur Ausführungsform der Fig. 1. Zur detaillierten Beschreibung der Funktionalität bzw. der Kalibrierung der Fehlerstromeinrichtung 1 der Fig. 2 kann daher im Wesentlichen auf das oben zur Fehlerstromeinrichtung 1 der Fig. 1 Gesagte verwiesen werden.

Den drei Phasenleitern L1, L2, L3 entsprechend weist die Fehlerstromschutzeinrichtung 1 der Fig. 2 ebenfalls drei Phasenleiter 3, 3', 3" auf, die mit den Phasenleitern L1, L2, L3 verbunden sind. Die Primärwicklung 18 des Differenzstrom-Transformators 12 wird in diesem Fall durch jeweils einen Abschnitt der Phasenleiter 3, 3', 3" und des Nullleiters 4 gebildet. Dabei sind diese Abschnitte der Phasenleiter 3, 3', 3" und des Nullleiters 4 durch den ringförmigen Kern 21 hindurch verlaufend angeordnet.

Es versteht sich, dass für alle drei Phasenleiter 3, 3', 3" zugehörige Phasenleiter-Schaltkontakte 6, 6', 6" vorgesehen sind. Im gezeigten Ausführungsbeispiel sind drei Relais 9, 9', 9" vorgesehen, um die Phasenleiter-Schaltkontakte 6, 6', 6" schalten zu können. Das Schalten der einzelnen Phasenleiter-Schaltkontakte 6, 6', 6" kann dabei unabhängig voneinander erfolgen, oder die Phasenleiter-Schaltkontakte 6, 6', 6" werden stets gleichzeitig geschaltet.

### BEZUGSZEICHENLISTE

- 1: Fehlerstromschutzeinrichtung
- 2: Schutzleiter der Fehlerstromschutzeinrichtung
- 3, 3', 3": Phasenleiter der Fehlerstromschutzeinrichtung
- 4: Nullleiter der Fehlerstromschutzeinrichtung
- 5: Schutzleiter-Schaltkontakt
- 6, 6', 6": Phasenleiter-Schaltkontakt
- 7: Nullleiter-Schaltkontakt
- 8: Relais zum Schalten des Schutzleiter-Schaltkontakts
- 9, 9', 9": Relais zum Schalten des Phasenleiter-Schaltkontakts
- 10: Relais zum Schalten des Nullleiter-Schaltkontakts
- 11: Steuereinheit
- 12: Differenzstrom-Transformator
- 13: Stromversorgung der Steuereinheit
- 14: Eingang der Steuereinheit für eine Sekundärspannung und/oder einen Sekundärstrom
- 15: Ausgang der Steuereinheit für einen Prüfstrom
- 16: Ausgang der Steuereinheit zur Ansteuerung der Relais
- 17: Weiterführender Anschluss
- 18: Primärwicklung
- 19: Sekundärwicklung
- 20: Prüfwicklung
- 21: Kern des Differenzstrom-Transformators
- 22: Einschalttaste
- L, L1, L2, L3: Phasenleiter des Niederspannungsnetzes
- N: Nullleiter des Niederspannungsnetzes
- PE: Schutzleiter des Niederspannungsnetzes

## Patentansprüche

1. Fehlerstromschutzeinrichtung (1) umfassend einen Differenzstrom-Transformator (12), der eine Primärwicklung (18) beinhaltend mindestens einen Phasenleiter (3, 3', 3") und einen Nullleiter (4) aufweist sowie einen Kern (21), eine Sekundärwicklung (19) und eine Prüfwicklung (20), mit welcher der Differenzstrom-Transformator (12) mit einem Prüfstrom beaufschlagbar ist, um einen definierten Differenzstrom zu simulieren, die Fehlerstromschutzeinrichtung (1) weiters umfassend eine Steuereinheit (11), um die Prüfwicklung (20) zur Erzeugung des Prüfstroms anzusteuern und um eine in der Sekundärwicklung (19) induzierte Sekundärspannung und/oder einen aus der induzierten Sekundärspannung resultierenden Sekundärstrom zu messen, **dadurch gekennzeichnet, dass** die Steuereinheit (11) zur Kalibrierung der Fehlerstromschutzeinrichtung (1) so ausgelegt ist, dass bei einer Abweichung des gemessenen Spannungswerts der durch den Prüfstrom verursachten Sekundärspannung von einem Spannungssollwert und/oder bei einer Abweichung des gemessenen Stromwerts des durch den Prüfstrom verursachten Sekundärstroms von einem Stromsollwert ein Korrekturfaktor berechnet wird, mit dem gemessene Spannungswerte der durch Differenzströme verursachten Sekundärspannung und/oder gemessene Stromwerte des durch Differenzströme verursachten Sekundärstroms multipliziert werden, wobei die Steuereinheit (11) so ausgelegt ist, dass ein Kalibrierungs-Fehlerzustand erkannt wird, wenn der Korrekturfaktor größer als ein vorgegebener maximal zulässiger Korrekturfaktor oder kleiner als ein vorgegebener minimal zulässiger Korrekturfaktor ist.

2. Fehlerstromschutzeinrichtung (1) nach Anspruch 1, **dadurch gekennzeichnet, dass** die Fehlerstromschutzeinrichtung (1) mindestens einen Phasenleiter-Schaltkontakt (6, 6', 6") zur ein- und ausschaltbaren Unterbrechung des mindestens einen Phasenleiters (3, 3', 3") und einen Nullleiter-Schaltkontakt (7) zur ein- und ausschaltbaren Unterbrechung des Nullleiters (4) umfasst, wobei mindestens ein mittels der Steuereinheit (11) ansteuerbares Schaltmittel (9, 10) vorgesehen ist, um die Schaltkontakte (6, 6', 6", 7) zu schalten, und wobei die Steuereinheit (11) so ausgelegt ist, dass bei Erkennung des Kalibrierungs-Fehlerzustands die Schaltkontakte (6, 6', 6", 7) ausgeschaltet werden und/oder ein Einschalten der Schaltkontakte (6, 6', 6", 7) unterbunden wird.

3. Fehlerstromschutzeinrichtung (1) nach einem der Ansprüche 1 bis 2, **dadurch gekennzeichnet, dass** die Steuereinheit (11) so ausgelegt ist, dass die Kalibrierung der Fehlerstromschutzeinrichtung (1) zu Beginn jedes Einschaltens der Fehlerstromschutzeinrichtung (1), vorzugsweise jeweils unmittelbar nachdem eine Einschalttaste (22) der Fehlerstromschutzeinrichtung (1) durch einen Benutzer betätigt worden ist, durchgeführt wird.

4. Fehlerstromschutzeinrichtung (1) nach einem der Ansprüche 1 bis 3, **dadurch gekennzeichnet, dass** die Steuereinheit (11) so ausgelegt ist, dass die Kalibrierung der Fehlerstromschutzeinrichtung (1) bei eingeschalteter Fehlerstromschutzeinrichtung (1) erfolgt, vorzugsweise regelmäßig und/oder in vorgebbaren Zeitintervallen und/oder zu vorgebbaren Zeitpunkten.

5. Fehlerstromschutzeinrichtung (1) nach einem der Ansprüche 1 bis 4, **dadurch gekennzeichnet, dass** es sich um eine ortsveränderliche Fehlerstromschutzeinrichtung (1) handelt.

6. System zur lokalen Bereitstellung von Wechselstrom umfassend eine Fehlerstromschutzeinrichtung (1) nach einem der Ansprüche 1 bis 5, wobei ein Schutzleiter (2) der Fehlerstromschutzeinrichtung (1) mit einem Schutzleiter (PE) des Niederspannungsnetzes elektrisch verbunden ist, wobei der Nullleiter (4) der Fehlerstromschutzeinrichtung (1) mit einem Nullleiter (N) des Niederspannungsnetzes elektrisch verbunden ist und wobei der mindestens eine Phasenleiter (3, 3', 3") der Fehlerstromschutzeinrichtung (1) mit mindestens einem Phasenleiter (L; L1, L2, L3) des Niederspannungsnetzes elektrisch verbunden ist.

7. Verfahren zur Kalibrierung einer Fehlerstromschutzeinrichtung (1), welche einen Differenzstrom-Transformator (12) umfasst, der eine Primärwicklung (18) beinhaltend mindestens einen Phasenleiter (3, 3', 3") und einen Nullleiter (4) aufweist sowie einen Kern (21), eine Sekundärwicklung (19) und eine Prüfwicklung (20), wobei das Verfahren die folgenden Schritte umfasst:
- Beaufschlagen des Differenzstrom-Transformators (12) mit einem Prüfstrom mittels der Prüfwicklung (20), um einen definierten Differenzstrom zu simulieren;
- Messen eines Spannungswerts einer durch den Prüfstrom verursachten, in der Sekundärwicklung (19) induzierten Sekundärspannung und/oder eines Stromwerts eines aus der induzierten Sekundärspannung resultierenden Sekundärstroms;
**dadurch gekennzeichnet, dass** das Verfahren die folgenden Schritte umfasst:
- Berechnen eines Korrekturfaktors, wenn der gemessene Spannungswert von einem Spannungssollwert und/oder der gemessene Stromwert von einem Stromsollwert abweicht;
- Multiplizieren von gemessenen Spannungswerten der durch Differenzströme verursachten Sekundärspannung und/oder von gemessenen Stromwerten des durch Differenzströme verursachten Sekundärstroms mit dem Korrekturfaktor;
- Erkennen eines Kalibrierungs-Fehlerzustands, wenn der Korrekturfaktor größer als ein vorgegebener maximal zulässiger Korrekturfaktor oder kleiner als ein vorgegebener minimal zulässiger Korrekturfaktor ist.

8. Verfahren nach Anspruch 7, **dadurch gekennzeichnet, dass** bei Erkennung des Kalibrierungs-Fehlerzustands der mindestens eine Phasenleiter (3, 3', 3") und der Nullleiter (4) unterbrochen werden und/oder bleiben.

9. Verfahren nach einem der Ansprüche 7 bis 8, **dadurch gekennzeichnet, dass** das Verfahren zu Beginn jedes Einschaltens der Fehlerstromschutzeinrichtung (1), vorzugsweise jeweils unmittelbar nachdem eine Einschalttaste (22) der Fehlerstromschutzeinrichtung (1) durch einen Benutzer betätigt worden ist, durchgeführt wird.

10. Verfahren nach einem der Ansprüche 7 bis 9, **dadurch gekennzeichnet, dass** das Verfahren bei eingeschalteter Fehlerstromschutzeinrichtung (1) durchgeführt wird, vorzugsweise regelmäßig und/oder in vorgebbaren Zeitintervallen und/oder zu vorgebbaren Zeitpunkten.

## Claims

1. A residual current device (1) comprising a residual current transformer (12), which has a primary winding (18) containing at least one phase conductor (3, 3', 3") and a neutral conductor (4) and also a core (21), a secondary winding (19), and a test winding (20), using which a test current can be applied to the residual current transformer (12) to simulate a defined residual current, the residual current device (1) furthermore comprising a control unit (11) to activate the test winding (20) to generate the test current and to measure a secondary voltage induced in the secondary winding (19) and/or a secondary current resulting from the induced secondary voltage, **characterized in that** the control unit (11) is designed for calibrating the residual current device (1) so that in the event of a deviation of the measured voltage value of the secondary voltage caused by the test current from a voltage setpoint value and/or in the event of a deviation of the measured current value of the secondary current caused by the test current from a current setpoint value, a correction factor is computed, by which measured voltage values of the secondary voltage caused by residual currents and/or measured current values of the secondary current caused by residual currents are multiplied, wherein the control unit (11) is designed so that a calibration fault state is recognized if the correction factor is greater than a predefined maximum permissible correction factor or less than a predefined minimum permissible correction factor.

2. The residual current device (1) according to Claim 1, **characterized in that** the residual current device (1) comprises at least one phase conductor switching contact (6, 6', 6") for interruption, which can be turned on and off, of the at least one phase conductor (3, 3', 3") and a neutral conductor switching contact (7) for interruption, which can be turned on and off, of the neutral conductor (4), wherein at least one switching means (9, 10) activatable by means of the control unit (11) is provided, to switch the switching contacts (6, 6', 6", 7), and wherein the control unit (11) is designed so that upon recognition of the calibration fault state, the switching contacts (6, 6', 6", 7) are turned off and/or turning on of the switching contacts (6, 6', 6", 7) is suppressed.

3. The residual current device (1) according to any one of Claims 1 to 2, **characterized in that** the control unit (11) is designed so that the calibration of the residual current device (1) is carried out at the beginning of each turning-on procedure of the residual current device (1), preferably in each case immediately after a turning-on button (22) of the residual current device (1) has been actuated by a user.

4. The residual current device (1) as claimed in any one of Claims 1 to 3, **characterized in that** the control unit (11) is designed so that the calibration of the residual current device (1) takes place with turned-on residual current device (1), preferably regularly and/or at predefinable time intervals and/or at predefinable points in time.

5. The residual current device (1) as claimed in any one of Claims 1 to 4, **characterized in that** it is a portable residual current device (1).

6. A system for the local provision of alternating current comprising a residual current device (1) according to any one of Claims 1 to 5, wherein a protective conductor (2) of the residual current device (1) is electrically connected to a protective conductor (PE) of the low-voltage network, wherein the neutral conductor (4) of the residual current device (1) is electrically connected to a neutral conductor (N) of the low-voltage network, and wherein the at least one phase conductor (3, 3', 3") of the residual current device (1) is electrically connected to at least one phase conductor (L; L1, L2, L3) of the low-voltage network.

7. A method for calibrating a residual current device (1), which comprises a residual current transformer (12), which has a primary winding (18) containing at least one phase conductor (3, 3', 3") and a neutral conductor (4) and also a core (21), a secondary winding (19), and a test winding (20), wherein the method comprises the following steps:
- applying a test current to the residual current transformer (12) by means of the test winding (20) to simulate a defined residual current;
- measuring a voltage value of a secondary voltage, which is caused by the test current and induced in the secondary winding (19), and/or a current value of a secondary current resulting from the induced secondary voltage;
**characterized in that** the method comprises the following steps:
- computing a correction factor if the measured voltage value deviates from a voltage setpoint value and/or the measured current value deviates from a current setpoint value;
- multiplying measured voltage values of the secondary voltage caused by residual currents and/or measured current values of the secondary current caused by residual currents by the correction factor;
- recognizing a calibration fault state if the correction factor is greater than a predefined maximum permissible correction factor or less than a predefined minimum permissible correction factor.

8. The method according to Claim 7, **characterized in that** upon recognition of the calibration fault state, the at least one phase conductor (3, 3', 3") and the neutral conductor (4) are and/or remain interrupted.

9. The method according to any one of Claims 7 to 8, **characterized in that** the method is carried out at the beginning of each turning-on procedure of the residual current device (1), preferably in each case immediately after a turning-on button (22) of the residual current device (1) has been actuated by a user.

10. The method according to any one of Claims 7 to 9, **characterized in that** the method is carried out with turned-on residual current device (1), preferably regularly and/or at predefinable time intervals and/or at predefinable points in time.

## Revendications

1. Dispositif de protection à courant de défaut (1) comprenant un transformateur de courant différentiel (12) qui présente un enroulement primaire (18) contenant au moins un conducteur de phase (3, 3', 3") et un conducteur neutre (4) ainsi qu'un noyau (21), un enroulement secondaire (19) et un enroulement de contrôle (20) avec lequel le transformateur de courant différentiel (12) peut être soumis à un courant de contrôle pour simuler un courant différentiel défini, le dispositif de protection à courant de défaut (1) comprenant en outre une unité de commande (11) pour commander l'enroulement de contrôle (20) afin de produire le courant de contrôle et pour mesurer une tension secondaire induite dans l'enroulement secondaire (19) et/ou un courant secondaire résultant de la tension secondaire induite, **caractérisé en ce que** l'unité de commande (11) est conçue pour étalonner le dispositif de protection à courant de défaut (1) de telle sorte qu'en cas d'écart de la valeur de tension mesurée de la tension secondaire produite par le courant de contrôle par rapport à une valeur de consigne de tension et/ou en cas d'écart de la valeur de courant mesurée du courant secondaire produit par le courant de contrôle par rapport à une valeur de consigne de courant, un facteur de correction est calculé, par lequel des valeurs de tension mesurées de la tension secondaire produite par des courants différentiels et/ou des valeurs de courant mesurées du courant secondaire produit par des courants différentiels sont multipliées, l'unité de commande (11) étant conçue de telle sorte qu'un état de défaut d'étalonnage est détecté lorsque le facteur de correction est supérieur à un facteur de correction maximal admissible prédéfini ou inférieur à un facteur de correction minimal admissible prédéfini.

2. Dispositif de protection à courant de défaut (1) selon la revendication 1, **caractérisé en ce que** le dispositif de protection à courant de défaut (1) comprend au moins un contact de commutation de conducteur de phase (6, 6', 6") pour l'interruption enclenchable et déclenchable dudit au moins un conducteur de phase (3, 3', 3") et un contact de commutation de conducteur neutre (7) pour l'interruption enclenchable et déclenchable du conducteur neutre (4), au moins un moyen de commutation (9, 10) pouvant être commandé par l'unité de commande (11) étant prévu pour commuter les contacts de commutation (6, 6', 6", 7) et l'unité de commande (11) étant conçue de telle sorte qu'en cas de détection de l'état de défaut d'étalonnage, les contacts de commutation (6, 6', 6", 7) sont déclenchés et/ou un enclenchement des contacts de commutation (6, 6', 6", 7) est empêché.

3. Dispositif de protection à courant de défaut (1) selon l'une des revendications 1 à 2, **caractérisé en ce que** l'unité de commande (11) est conçue de telle sorte que l'étalonnage du dispositif de protection à courant de défaut (1) est effectué au début de chaque enclenchement du dispositif de protection à courant de défaut (1), de préférence chaque fois immédiatement après qu'une touche d'enclenchement (22) du dispositif de protection à courant de défaut (1) a été actionnée par un utilisateur.

4. Dispositif de protection à courant de défaut (1) selon l'une des revendications 1 à 3, **caractérisé en ce que** l'unité de commande (11) est conçue de telle sorte que l'étalonnage du dispositif de protection à courant de défaut (1) a lieu, le dispositif de protection à courant de défaut (1) étant enclenché, de préférence régulièrement et/ou à des intervalles de temps prédéfinissables et/ou à des instants prédéfinissables.

5. Dispositif de protection à courant de défaut (1) selon l'une des revendications 1 à 4, **caractérisé en ce qu'**il s'agit d'un dispositif de protection à courant de défaut (1) mobile.

6. Système de fourniture locale de courant alternatif, comprenant un dispositif de protection à courant de défaut (1) selon l'une des revendications 1 à 5, dans lequel un conducteur de protection (2) du dispositif de protection à courant de défaut (1) est relié électriquement à un conducteur de protection (PE) du réseau à basse tension, dans lequel le conducteur neutre (4) du dispositif de protection à courant de défaut (1) est relié électriquement à un conducteur neutre (N) du réseau à basse tension et dans lequel au moins un conducteur de phase (3, 3', 3") du dispositif de protection à courant de défaut (1) est relié électriquement à au moins un conducteur de phase (L ; L1, L2, L3) du réseau à basse tension.

7. Procédé d'étalonnage d'un dispositif de protection à courant de défaut (1), lequel comprend un transformateur de courant différentiel (12) qui présente un enroulement primaire (18) contenant au moins un conducteur de phase (3, 3', 3") et un conducteur neutre (4) ainsi qu'un noyau (21), un enroulement secondaire (19) et un enroulement de contrôle (20), le procédé comprenant les étapes consistant à :
- soumettre au moyen de l'enroulement de contrôle (20) le transformateur de courant différentiel (12) à un courant de contrôle pour simuler un courant différentiel défini ;
- mesurer une valeur de tension d'une tension secondaire produite par le courant de contrôle, induite dans l'enroulement secondaire (19) et/ou une valeur de courant d'un courant secondaire résultant de la tension secondaire induite ;
**caractérisé en ce que** le procédé comprend les étapes suivantes consistant à :
- calculer un facteur de correction lorsque la valeur de tension mesurée s'écarte d'une valeur de consigne de tension et/ou la valeur de courant mesurée s'écarte d'une valeur de consigne de courant ;
- multiplier par le facteur de correction des valeurs de tension mesurées de la tension secondaire produite par des courants différentiels et/ou des valeurs de courant mesurées du courant secondaire produit par des courants différentiels ;
- détecter un état de défaut d'étalonnage lorsque le facteur de correction est supérieur à un facteur de correction maximal admissible prédéfini ou inférieur à un facteur de correction minimal admissible prédéfini.

8. Procédé selon la revendication 7, **caractérisé en ce qu'**en cas de détection de l'état de défaut d'étalonnage, ledit au moins un conducteur de phase (3, 3', 3") et le conducteur neutre (4) sont et/ou restent interrompus.

9. Procédé selon l'une des revendications 7 à 8, **caractérisé en ce que** le procédé est exécuté au début de chaque enclenchement du dispositif de protection à courant de défaut (1), de préférence chaque fois immédiatement après qu'une touche d'enclenchement (22) du dispositif de protection à courant de défaut (1) a été actionnée par un utilisateur.

10. Procédé selon l'une des revendications 7 à 9, **caractérisé en ce que** le procédé est exécuté, le dispositif de protection à courant de défaut (1) étant enclenché, de préférence régulièrement et/ou à des intervalles de temps prédéfinissables et/ou à des instants prédéfinissables.
